# EUROPEAN PATENT SPECIFICATION

(11) **EP 0 343 906 B1**
(45) Date of publication and mention of the grant of the patent: **02.03.1994**
(21) Application number: 89305166.4
(22) Date of filing: 22.05.1989
(51) Int. Cl.: G01R 23/165, G01R 23/16, H03G 5/02

(54) **Spectrum analysers**
Spektralanalysator
Analyseur de spectre

(30) Priority: 24.05.1988 JP 126680/88
(43) Date of publication of application: 29.11.1989
(73) Proprietor: SONY CORPORATION, Tokyo 141 (JP)
(72) Inventor: Ohsawa, Mitsuo c/o Patents Division, Shinagawa-ku Tokyo 141 (JP)
(74) Representative: Pilch, Adam John Michael

(56) References cited:
- EP-A- 0 217 953
- DE-A- 2 940 088
- GB-A- 2 034 056
- GB-A- 2 072 915
- PATENT ABSTRACTS OF JAPAN, vol. 8, no. 198 (E-265)[1635], 11th September 1984; & JP-A-59 86 913 (SANYO DENKI K.K.) 19-05-1984

## Description

This invention relates to spectrum analyzers, and in particular to spectrum analysers suitable for use in graphic equalisers.

When reproducing an audio signal in a special sound environment or field, such as in an automobile, it is known to compensate for the sound field by employing a graphic equaliser, for example as shown in Japanese Published Patent Application No. JP-A-59-86913. In such a graphic equalizer, the reproduced audio signal is divided into a number of frequency bands, and the signal levels of the divided bands are adjusted relative to each other so as to compensate for the sound field. A graphic equalizer of this type usually has a spectrum analyser associated therewith for displaying the signal levels of the several frequency bands in the form of respective bar graphs. In that case, as the signal levels of the several frequency bands are adjusted, the relationship of the adjusted signal levels can be ascertained by observing the bar graphs of the spectrum analyzer.

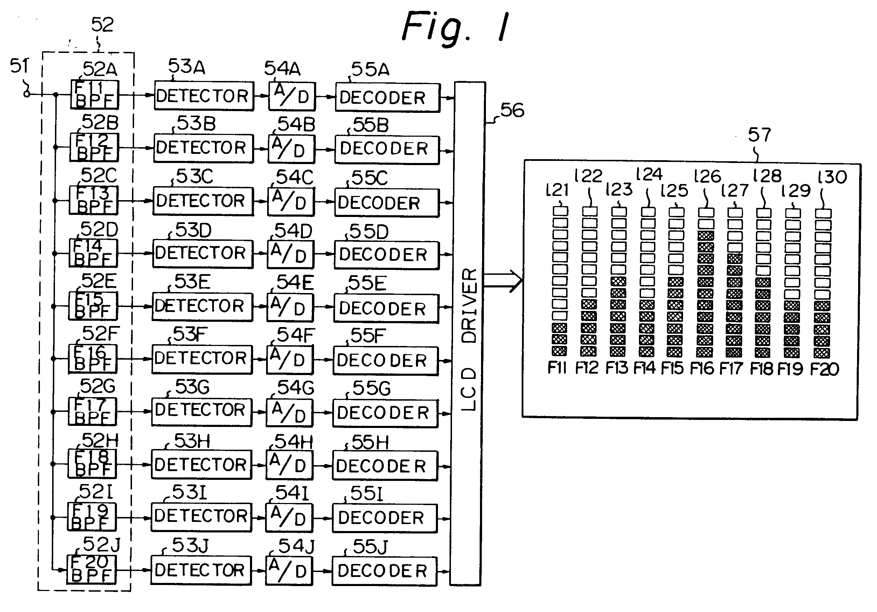

A spectrum analyser of this kind is shown in Figure 1 of the accompanying drawings as including an input terminal 51 from which an input signal, for example, an audio signal reproduced from a tape cassette, is supplied to a multiband band-pass filter circuit 52. The multiband band-pass filter circuit 52 comprises a plurality of, such as ten, band-pass filters 52A to 52J having respective pass bands with different centre frequencies. More specifically, in the illustrated example, the ten band-pass filters 52A to 52J making up the multiband band-pass filter circuit 52 have centre frequencies F11 to F20, respectively. Thus, the audio signal from the input terminal 51 is divided by the multiband band-pass filter circuit 52 into ten components or frequency bands which are respectively centred about the frequencies F11 to F20.

Outputs of the band-pass filters 52A to 52J are supplied to corresponding detecting circuits 53A to 53J which detect the signal levels of the ten frequency components or bands having the respective centre frequencies F11 to F20. The detected signal level outputs from the detecting circuits 53A to 53J are supplied to respective analog to digital (A/D) converters 54A to 54J which provide digital data representing the signal levels of the frequency bands having the respective centre frequencies F11 to F20. The digital data from the A/D converters 54A to 54J is supplied to respective decoders 55A to 55J, and each of the decoders 55A to 55J converts the digital data supplied thereto (representing the signal level of a respective divided frequency band of the input signal) into a decoded signal corresponding to one of a predetermined number of, for example thirteen, steps or increments corresponding to respective dots or elements of an associated bar graph. The decoded outputs from the decoders 55A to 55J are supplied through a driver 56 to a display device 57.

The display device 57 may conventionally be a liquid crystal display (LCD) having a column of dots for each of the frequency bands into which the input signal is divided by the band-pass filter circuit 52, with each such column having a number of dots therein corresponding to the number of increments or steps into which each of the decoders 55A to 55J converts the respective digital data from the A/D converter 54A to 54J. Thus, in the illustrated spectrum analyser, the LCD display device 57 includes ten vertically extending columns 121 to 130 arranged in a horizontal series and each comprising thirteen dots which are selectively excited, starting from the bottom of the respective column, for defining a bar graph representing the signal level of the respective frequency band divided from the input signal.

It will be appreciated that, in the spectrum analyser shown in Figure 1, the adjusted levels of the several frequency components divided by the multiband band-pass filter circuit 52 so as to have centre frequencies F11 to F20 are detected by the detecting circuits 53A to 53J and then respectively displayed by the columns 121 to 130 of LCD dots or elements, as represented by the shaded areas in Figure 1. Thus, in the illustrated example, the input signal is divided into ten frequency components having the respective centre frequencies F11 to F20, and the signal levels of the ten frequency bands are displayed by the ten respective bar graphs defined by the columns 121 to 130 of the display device 57. When fine adjustment of the frequency characteristic of an audio or other signal applied as the input to the terminal 51 is to be effected, it is desirable to increase the number of frequency bands which have their signal levels indicated by the display device 57. In other words, when only a relatively small number of frequency bands have their signal levels indicated by the display device 57, it is difficult to visualise an image of the resulting frequency characteristic. If the number of frequency bands having their signal levels indicated by the display device 57 is increased, a curve representing the frequency characteristic of the reproduced audio signal can be more easily visualised from the increased number of bar graphs defined by the display device 57.

However, in the known spectrum analyser, the number of frequency bands or components which have their signal levels indicated by the display device 57 corresponds to the number of frequency bands divided by the multiband band-pass filter circuit 52. Therefore, in order to increase the number of frequency bands which are to have their signal levels indicated by the display device 57, it is necessary to increase correspondingly the number of band-pass filters included in the filter circuit 52. For example, in order to permit signal levels of nineteen frequency bands or components to be displayed, it would be necessary to provide nineteen band-pass filters in the filter circuit 52. Furthermore, it would be necessary similarly to increase the numbers of detecting circuits, A/D converters and decoders provided in succession after the nineteen band-pass filters. Therefore, in the known spectrum analyser, an increase in the number of frequency bands which are to have their signal levels indicated by the display device 57 is achieved only at the expense of substantially increasing the complexity and cost of the associated circuit.

UK Patent Application No. GB-A-2 034 056 discloses a similar spectrum analyser in which it is possible to hold the levels of the displayed frequency bands for a predetermined time upon actuation of a control switch.

In accordance with this invention there is provided a spectrum analyser comprising:
means for dividing an input signal into a plurality of frequency bands;
means for detecting the respective signal levels of said frequency bands into which the input signal is divided; and
display means for displaying said detected signal levels of the divided frequency bands;
characterised by:
means for determining, from the detected signal levels of the divided frequency bands which are adjacent each other, signal levels of frequency bands situated between said adjacent divided frequency bands; and
the display means also displaying the signal levels which are determined for said frequency bands situated between said divided frequency bands adjacent thereto.

In a preferred embodiment of this invention described hereinafter, the signal levels of frequency bands situated between the divided frequency bands adjacent thereto are calculated by arithmetic operating means which, for example, calculates the signal level of each of the frequency bands situated between the divided frequency bands as the mean value of the signal levels of the two divided frequency bands adjacent thereto.

Accordingly, the preferred embodiment of this invention provides a spectrum analyser in which the number of frequency components or bands of the input signal which have their levels displayed can be increased without substantially increasing the complexity and cost of the associated circuit.

The invention will now be described by way of example with reference to the accompanying drawings, throughout which like parts are referred to by like references, and in which:
Figure 1 is a block diagram of a known spectrum analyser;
Figure 2 is a block diagram of a spectrum analyser according to an embodiment of the present invention;
Figure 3 is a frequency characteristic diagram showing the characteristic of a multiband band-pass filter included in the spectrum analyser of Figure 2;
Figure 4 is a graph to which reference will be made in explaining the operation of the spectrum analyser embodying the invention; and
Figure 5 is a schematic plan view of a liquid crystal display device included in the spectrum analyser of Figure 2, and to which reference will be made in explaining the operation thereof.

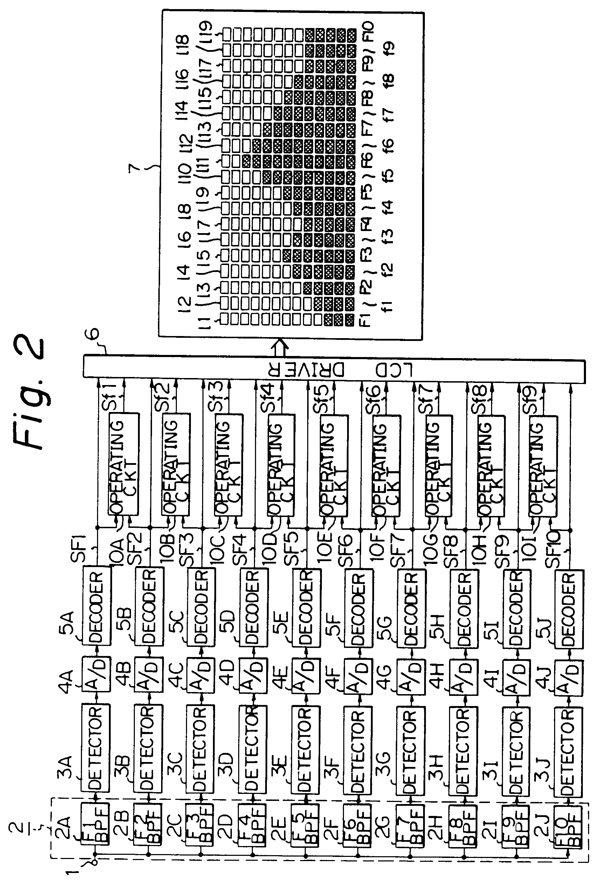

Referring to the drawings in detail, and initially to Figure 2 thereof, it will be seen that a graphic equalizer in accordance with an embodiment of this invention which is particularly suitable for installation in an automobile or other vehicle comprises an input terminal 1 through which a reproduced audio signal is supplied to a multiband band-pass filter circuit 2. The filter circuit 2 includes a number of, for example ten, band-pass filters 2A to 2J having respective pass bands with different centre frequencies.

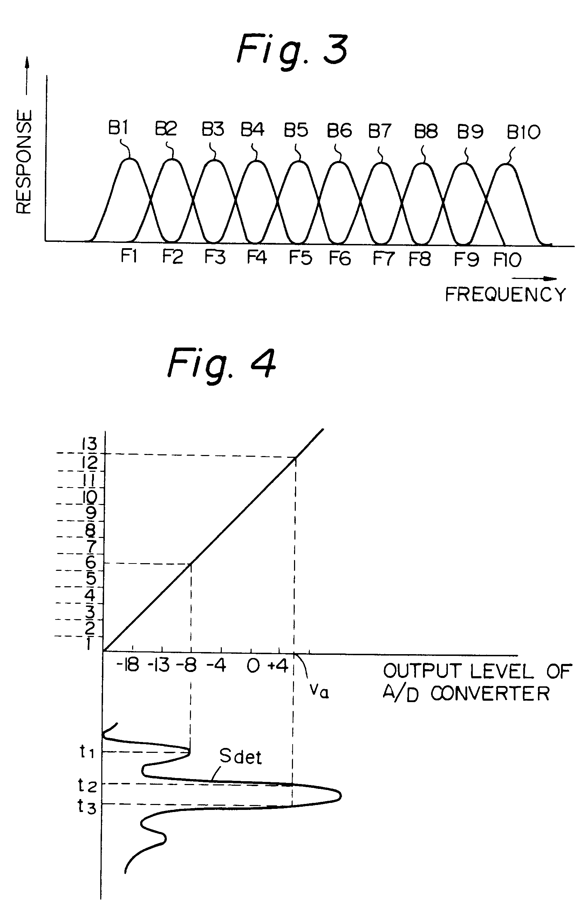

In the illustrated embodiment, the band-pass filters 2A to 2J constituting the multiband band-pass filter circuit 2 desirably have respective frequency characteristics indicated at B1 to B10 in Figure 3 so as to pass frequency bands with the centre frequencies F1 to F10. More particularly, the centre frequencies F1, F2, F3, --- of the band-pass filters 2A, 2B, 2C, --- are desirably selected to be spaced apart equally along a log scale, for example, the centre frequencies may be 60Hz, 100Hz, 180Hz, ---, respectively. In other words, the frequency ratios between the centre frequencies of the adjacent frequency bands passed by the filters are approximately 1.7 to 2.0. Thus, the audio signal from the input terminal 1 is divided into ten frequency bands or components having the centre frequencies F1 to F10 by the ten respective band-pass filters 2A to 2J constituting the filter circuit 2, with such centre frequencies being equally spaced apart along a log scale to conform to the conventional use of a log scale for plotting the frequencies on a frequency characteristic graph.

The outputs of the band-pass filters 2A to 2J are supplied to respective detecting circuits 3A to 3J, which detect the signal levels of the ten frequency components or bands. The detected signal level outputs from the detecting circuits 3A to 3J are supplied to respective analog to digital (A/D) converters 4A to 4J which provide digital data representing the signal levels of the frequency bands having the respective centre frequencies F1 to F10. The digital data from the A/D converters 4A to 4J is supplied to respective decoders 5A to 5J, in which the digital data supplied thereto and representing the signal levels of the respective divided frequency bands of the input signal are converted into decoded signals each corresponding to one of a predetermined number of, for example thirteen, steps or levels corresponding to respective dots or elements of associated bar graphs.

More specifically, and as shown in Figure 4, if it is assumed that the detected signal level output Sdet is obtained from one of the detecting circuits 3A to 3J, such detected output is digitized by the respective one of the A/D converters 4A to 4J to the corresponding digital value indicated along the horizontal axis or abscissa of the graph in Figure 4. That digital value is converted by the respective one of the decoders 5A to 5J into a corresponding one of the thirteen levels or steps indicated along the vertical axis or ordinate of the graph of Figure 4. For example, if the detected output Sdet is that indicated at the time t1 in Figure 4, such detected output is converted into a digital value corresponding to -8dB by the respective one of the A/D converters 4A to 4J, and is thereafter further converted into the decoded value "6" by the respective one of the decoders 5A to 5J. Although the outputs of the decoders 5A to 5J vary substantially linearly with the digital outputs of the respective A/D converters 4A to 4J, such substantially linear correspondence exists only up to the digital value Va. In other words, the upper limit of the decoded values or signals from the decoders 5A to 5J is "thirteen" and corresponds to the digital value Va, and the decoded values or signals remain at "thirteen" for any digital values above Va. Thus, in the situation shown in Figure 4, the decoded value of the detected output Sdet at each of times t2 and t3 is "thirteen" for the digital value Va, and the decoded value remains at "thirteen" even when the detected output is increased between the times t2 and t3 to provide a digital value above Va.

Returning to Figure 2, decoded outputs SF1 to SF10 of the decoders 5A to 5J are supplied through an LCD driver 6 to an LCD display device 7. As shown, the LCD display device 7 has columns l1, l3, l5 --- l19 of dots for displaying levels of the ten frequency bands with the respective centre frequencies F1, F2, F3, --- F10, into which the input signal is divided by the multiband band-pass filter circuit 2, with each such column having thirteen dots therein corresponding to the increments or levels of the decoded outputs from the decoders 5A to 5J.

The signal levels of frequency bands situated between the frequency bands divided by the filter circuit 2 are calculated, for example, by nine arithmetic operating circuits 10A to 10I, from the detected signal levels of the divided frequency bands adjacent thereto, whereupon outputs Sf1 to Sf9 of the respective operating circuits 10A to 10I, which represent the calculated signal levels of the frequency bands between the divided frequency bands adjacent thereto, are also supplied through the LCD driver 6 for controlling the heights of bar graphs represented on the LCD display device 7 by columns l2, l4, l6, --- l18 interspersed between the columns l1, l3, l5, --- l19.

In the embodiment of the invention illustrated in Figure 2, the arithmetic operating circuits 10A to 10I calculate the signal levels of the frequency bands having respective centre frequencies f1 to f9, and which are situated between the divided frequency bands having the centre frequencies F1 to F10, from the decoded values or outputs SF1 to SF10 of the respective decoders 5A to 5J. More specifically, the outputs SF1 to SF2 of the decoders 5A and 5B are supplied to the arithmetic operating circuit 10A which calculates its output Sf1 as the mean value of the respective decoded outputs or levels SF1 and SF2. Similarly, the outputs SF2 and SF3 of the decoders 5B and 5C are supplied as the inputs to the arithmetic operating circuit 10B which provides the calculated value Sf2 as its output; the outputs SF3 and SF4 of the decoders 5C and 5D are supplied to the arithmetic operating circuit 10C which provides the calculated level or value Sf3 as its output; the outputs SF4 and SF5 of the decoders 5D and 5E are supplied to the arithmetic operating circuit 10D which provides the calculated level or value Sf4 as its output; the outputs SF5 and SF6 are supplied from the decoders 5E and 5F to the arithmetic operating circuit 10E which provides the calculated level or value Sf5 as its output; the outputs SF6 and SF7 are supplied from the decoders 5F and 5G to the arithmetic operating circuit 10F which provides the calculated value or level Sf6 as its output; the outputs SF7 and SF8 are supplied from the decoders 5G and 5H to the arithmetic operating circuit 10G which provides the calculated level or value Sf7 as its output; the outputs SF8 and SF9 are supplied from the decoders 5H and 5I to the arithmetic operating circuit 10H which provides the calculated level or value Sf8 as its output; and the outputs SF9 and SF10 are supplied from the decoders 5I and 5J to the arithmetic operating circuit 10I which provides the calculated level or value Sf9 as its output.

Similarly to the arithmetic operating circuit 10A, each of the arithmetic operating circuits 10B to 10I calculates the mean value of the outputs of the two decoders which are input thereto. In other words, each of the arithmetic operating circuits 10A to 10I executes the arithmetic operation

$\text{Sfn = (SFn + SFn+1)/2}$

in which Sfn is the output from the arithmetic operating circuit, and SFn and SFn+1 are the outputs of the two decoders which are supplied as inputs to the arithmetic operating circuit in question. The mean value Sfn of the levels SFn and SFn+1 of the two adjacent frequency bands having the centre frequencies Fn and Fn+1, as obtained by each of the arithmetic operating circuits 10A to 10I, substantially corresponds to the level of a frequency band which is intermediate or between the frequency bands or components having the respective centre frequencies Fn and Fn+1. Since the centre frequencies F1, F2, F3, --- F10 of the frequency bands divided from the input signal by the filter circuit 2 are selected to be equally spaced apart along a log scale, it is apparent that the mean value Sfn of the levels SFn and SFn+1 of the two adjacent frequency bands having the centre frequencies Fn and Fn+1 will be the level of the frequency band having a centre frequency which is midway between the frequencies Fn and Fn+1 plotted on a log scale. In other words, the calculated mean value Sfn will be the level of the frequency band having the centre frequency ${\text{fn = (Fn x Fn+1)}}^{\text{1/2}}$ 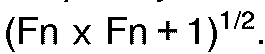 .

In view of the above, when for example, the frequencies F1, F2, F3, F4, --- are selected to be 60Hz, 100Hz, 180Hz, 300Hz, ---, the calculated mean value Sf1 obtained by the arithmetic operating circuit 10A from the levels of the frequency bands having the respective centre frequencies F1 and F2, corresponds to a frequency band having the centre frequency f1 of 77Hz. Similarly, the calculated mean value Sf2 obtained by the arithmetic operating circuit 10B from the levels of the frequency bands having the respective centre frequencies F2 and F3 corresponds to a frequency band having the centre frequency f2 of 134Hz, and the calculated mean value or level SF3 provided by the arithmetic operating circuit 10C from the levels of the frequency bands having the respective centre frequencies F3 and F4 corresponds to an intermediate frequency band having the intermediate centre frequency f3 of 232Hz.

The calculated levels Sf1, Sf2, Sf3, --- Sf9 of the frequency bands having the respective centre frequencies f1, f2, f3, --- f9, and which each represents the mean value of the levels SFn and SFn+1 of two adjacent frequency bands having the centre frequencies Fn and Fn+1, are supplied from the arithmetic operating circuits 10A to 10I to the LCD driver 6 for operating the respective columns l2, l4, l6, --- l18 of the LCD display device 7.

In the particular embodiment illustrated in Figure 2, the display device 7 comprises 247 dots arranged in a pattern or array consisting of nineteen columns l1-l19 arranged in succession in the horizontal direction and each consisting of thirteen dots arranged in succession in the vertical direction. The levels of the frequency components or bands having the centre frequencies F1, F2, F3, --- F10, and which are divided by the multiband band-pass filter 2, which levels are represented by the outputs SF1, SF2, SF3, --- SF10 of the respective decoders 5A, 5B, 5C, --- 5J are displayed as bar graphs defined by the alternate columns l1, l3, l5, --- l19 of the LCD display device 7. On the other hand, the calculated levels of the frequency bands having the centre frequencies f1, f2, f3, --- f9 which are intermediate adjacent ones of the frequencies F1, F2, F3, --- F10, are obtained as the outputs of the arithmetic operating circuits 10A, 10B, 10C, --- 10I, and are displayed as bar graphs represented by the respective columns l2, l4, l6, --- l18 of the display device 7. Therefore, the levels of nineteen successively arranged frequency components or bands are displayed as bar graphs by the LCD display device 7.

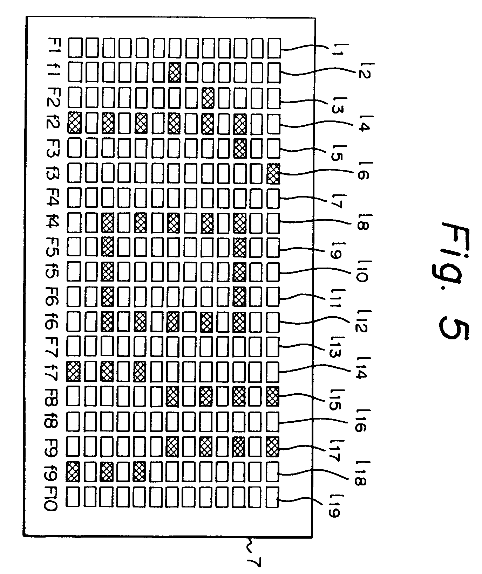

Since the LCD display device 7 is constituted by a large number of dots, for example 247 dots as described above, such display device can also be used to display characters or indicia, as indicated by the shaded areas appearing in Figure 5. In such a case, when each character is expressed by selected dots in a matrix measuring seven dots in the vertical direction and five dots in the horizontal direction, the display device 7 used in this embodiment can alternatively be used for simultaneously displaying three characters arranged side by side, with only every other dot being used in each of the vertically arranged columns of dots.

In the above-described embodiment of the invention, the outputs of the adjacent ones of the decoders 5A to 5J are averaged by the arithmetic operating circuits 10A to 10I to obtain the levels of the frequency bands which are intermediate the frequency bands divided by the filter circuit 2, but it will be apparent that the same results could be achieved with suitable software.

Since the outputs of the adjacent ones of the decoders 5A to 5J which are averaged to obtain the levels of the frequency bands intermediate the frequency bands divided by the filter circuit 2 are set to selected ones of thirteen different levels, the processes used for obtaining the average or mean level can be relatively simplified. Furthermore, instead of averaging the outputs of the adjacent ones of the decoders 5A to 5J, it is apparent that the outputs of the adjacent ones of the A/D converters 4A to 4J, or the outputs of the adjacent ones of the detecting circuits 3A to 3J, could be similarly averaged to obtain the levels of the frequency bands intermediate the frequency bands divided by the filter circuit 2.

Further, although the specifically-described embodiment calculates the level of only a single frequency band from the levels of the two adjacent frequency bands divided by the filter circuit 2, it will be apparent that the levels of two or more frequency bands or components between the adjacent divided frequency bands could be similarly calculated and displayed.

Moreover, instead of using the multiband band-pass filter circuit 2 for dividing the input signal into a plurality of frequency bands or components, the input signal could be similarly divided into a plurality of frequency components or bands by an FFT (fast fourier transformation).

By way of summary, in the present spectrum analyzing technique, in addition to detecting the levels of, for example, ten frequency bands or components into which the input signal is divided by the multiband band-pass filter circuit 2, the arithmetic operating circuits 10A to 10I calculate the levels of nine frequency components or bands corresponding to frequencies interspersed between the ten frequency bands divided by the filter circuit 2. Therefore, the levels of a total of nineteen different frequency components or bands can be displayed. By reason of the display of the levels of such a relatively large number of frequency bands, the frequency characteristic of the input signal can be readily and continuously recognized and such frequency characteristic can be finely adjusted. Moreover, since the increase in the number of frequency bands having their levels displayed is achieved without a corresponding increase in the number of band-pass filters included in the filter circuit 2, the size and complexity of the circuit arrangement, and hence the cost thereof, are not unduly increased. Further, since the calculated levels are determined from the levels of the adjacent frequency components or bands, the continuity of the resulting frequency characteristic appearing on the display device 7 is maintained. Furthermore, the frequency characteristic can be more readily recognized than in those cases where the number of band-pass filters included in the filter circuit 2 is increased to enable the levels of an increased number of frequency bands to be displayed.

## Claims

1. A spectrum analyser comprising:
means (2) for dividing an input signal into a plurality of frequency bands (B1 to B10);
means (3A to 3J) for detecting the respective signal levels of said frequency bands (B1 to B10) into which the input signal is divided; and
display means (7) for displaying said detected signal levels of the divided frequency bands (B1 to B10);
characterised by:
means (10A to 10I) for determining, from the detected signal levels of the divided frequency bands (B1 to B10) which are adjacent each other, signal levels of frequency bands situated between said adjacent divided frequency bands (B1 to B10); and
the display means (7) also displaying the signal levels which are determined for said frequency bands situated between said divided frequency bands adjacent thereto.

2. A spectrum analyser according to claim 1, in which said display means (7) includes means (l1 to l19) defining an array of bar graphs extending parallel to each other in succession and respectively corresponding to said detected signal levels of the divided frequency bands (B1 to B10) and said signal levels which are determined for the frequency bands situated between said divided frequency bands (B1 to B10).

3. A spectrum analyser according to claim 2, in which said display means includes liquid crystal display means (7) and drive means (6) therefor responsive to said detected and determined signal levels for causing said liquid crystal display means (7) to define the corresponding bar graphs.

4. A spectrum analyser according to claim 1, claim 2 or claim 3, in which said means for determining said signal levels of the frequency bands situated between said divided frequency bands adjacent thereto include arithmetic operating means (10A to 10I) for calculating the respective signal levels.

5. A spectrum analyser according to claim 4, in which said means (2) for dividing the input signal includes a plurality of band-pass filters (2A to 2J) having respective pass bands corresponding to said divided frequency bands (B1 to B10) and to which said input signal is supplied, said detecting means includes level detectors (3A to 3J) respectively connected to outputs of said band-pass filters (2A to 2J) for providing corresponding detected outputs, analog-to-digital converters (4A to 4J) for converting said detected outputs to corresponding digital signals, and decoders (5A to 5J) receiving respective ones of said digital signals and providing corresponding level-indicating values, and wherein said arithmetic operating means (10A to 10I) are operative to calculate said signal levels of the frequency bands situated between said divided frequency bands (B1 to B10) adjacent thereto from said level-indicating values corresponding to said adjacent divided frequency bands.

6. A spectrum analyser according to claim 5, in which said arithmetic operating means (10A to 10I) are operative to calculate said signal level of each of said frequency bands situated between said divided frequency bands (B1 to B10) as the mean value of said level-indicating values corresponding to the divided frequency bands adjacent thereto.

## Patentansprüche

1. Spektralanalysator, der aufweist:
Mittel (2) zum Teilen eines Eingangssignals in eine Vielzahl von Frequenzbändern (B1 bis B10);
Mittel (3A bis 3J) zum Ermitteln der jeweiligen Signalpegel der Frequenzbänder (B1 bis B10), in die das Eingangssignal geteilt ist; und
Anzeigemittel (7) zum Anzeigen der ermittelten Signalpegel der geteilten Frequenzbander (B1 bis B10);
gekennzeichnet durch:
Mittel (10A bis 10I) zum Bestimmen von Signalpegeln der Frequenzbänder, die zwischen den benachbarten geteilten Frequenzbändern (B1 bis B10) liegen, aus den Signalpegeln der geteilten Frequezbänder (B1 bis B10), die einander benachbart sind; und
Anzeigemittel (7), die auch die Signalpegel anzeigen, die für die Frequenzbänder bestimmt sind, die zwischen den geteilten Frequenzbändern benachbart dazu liegen.

2. Spektralanalysator nach Anspruch 1, bei dem die Anzeigemittel (7) Mittel (l1 bis l19) aufweisen, die eine Menge von graphischen Balken bestimmen, die sich parallel zueinander der Reihe nach erstrecken und jeweils den ermittelten Signalpegeln der geteilten Frequenzbänder (B1 bis B10) und den Signalpegeln entsprechen, die für die Frequenzbänder bestimmt sind, die zwischen den geteilten Frequenzbändern (B1 bis B10) liegen.

3. Spektralanalysator nach Anspruch 2, bei dem die Anzeigemittel eine Flüssigkristallanzeigeeinrichtung (7) und Treibermittel (6) dafür aufweisen, die auf die ermittelten und bestimmten Signalpegel antworten, um die Flüssigkristallanzeigeeinrichtung (7) zu veranlassen, die entsprechenden graphischen Balken zu bestimmen.

4. Spektralanalysator nach Anspruch 1, 2 oder 3, bei dem die Mittel zur Bestimmung der Signalpegel der Frequenzbänder, die zwischen den geteilten Frequenzbändern benachbart dazu liegen, arithmetische Berechnungsmittel (10A bis 10I) aufweisen, um die entsprechenden Signalpegel zu berechnen.

5. Spektralanalysator nach Anspruch 4, bei dem die Mittel (2) zur Teilung des Eingangssignals eine Vielzahl von Bandpaßfiltern (2A bis 2J) aufweisen, die entsprechende Bandpässe haben, die den geteilten Frequenzbändern (B1 bis B10) entsprechen und die mit dem Eingangssignal beliefert werden, wobei die Ermittlungsmittel Pegeldetektoren (3A bis 3J) aufweisen, die jeweils mit den Ausgängen der Bandpaßfilter (2A bis 2J) verbunden sind, um entsprechende ermittelte Ausgangssignale vorzusehen, weiter Analog-Digital-Konverter (4A bis 4J) aufweisen, um die ermittelten Ausgangssignale in entsprechende digitale Signale umzuwandeln, und Decodierer (5A bis 5J), die das jeweilige Signal der digitalen Signale empfangen und entsprechende pegelanzeigende Werte vorsehen, und wobei die arithmetischen Berechnungsmittel (10A bis 10I) die Signalpegel der Frequenzbänder, die zwischen den geteilten Frequenzbändern (B1 bis B10) benachbart dazu liegen, aus den pegelanzeigenden Werten berechnen können, die den benachbarten geteilten Frequenzbändern entsprechen.

6. Spektralanalysator nach Anspruch 5, bei dem die arithmetischen Berechnungsmittel (10A bis 10I) den Signalpegel jedes der Frequenzbänder, die zwischen den geteilten Frequenzbändern (B1 bis B10) liegen, als den Mittelwert der pegelanzeigenden Werte berechnen können, die den dazu benachbarten geteilten Frequenzbändern entsprechen.

## Revendications

1. Analyseur de spectre comprenant :
un dispositif (2) pour diviser un signal d'entrée en une pluralité de bandes de fréquence (B1 à B10);
un dispositif (3A à 3J) pour détecter les niveaux des signaux respectifs desdites bandes de fréquence (B1 à B10) dans lequel le signal d'entrée est divisé; et
un dispositif d'affichage (7) pour afficher lesdits niveaux de signaux détectés des bandes de fréquence divisées (B1 à B10);
caractérisé par :
des dispositifs (10A à 10I) pour déterminer, à partir des niveaux des signaux détectés des bandes de fréquence divisées (B1 à B10) qui sont voisines les unes des autres, des niveaux des signaux des bandes de fréquence situées entre lesdites bandes de fréquence divisées voisines (B1 à B10); et
le dispositif d'affichage (7) affichant aussi les niveaux des signaux qui sont déterminés pour lesdites bandes de fréquences situées entre lesdites bandes de fréquence divisées voisines de celles-ci.

2. Analyseur de spectre selon la revendication 1, dans lequel ledit dispositif de visualisation (7) comprend des dispositifs (l1 à l19), définissant un réseau d'histogrammes s'étendant parallèlement les uns aux autres successivement et correspondant respectivement auxdits niveaux de signaux détectés des bandes de fréquence divisées (B1 à B10) et lesdits niveaux de signaux qui sont déterminés pour les bandes de fréquence situées entre lesdites bandes de fréquence divisées (B1 à B10).

3. Analyseur de spectre selon la revendication 2, dans lequel ledit dispositif comprend des dispositifs d'affichage à cristaux liquides (7) et un dispositif de commande (6) de ceux-ci sensibles auxdits niveaux de signaux détectés et déterminés pour que ledit dispositif à cristaux liquides (7) définisse les histogrammes correspondants.

4. Analyseur de spectre selon la revendication 1, revendication 2 ou la revendication 3, dans lequel ledit dispositif pour déterminer lesdits niveaux des signaux desdites bandes de fréquence situées entre lesdites bandes de fréquence divisées voisines de celles-ci comprend des dispositifs d'opérations arithmétiques (10A à 10I) pour calculer les niveaux des signaux respectifs.

5. Analyseur de spectre selon la revendication 4, dans lequel ledit dispositif (2) pour diviser le signal d'entrée comprend une pluralité de filtres passe-bande (2A à 2J) ayant des bandes passantes respectives correspondant auxdites bandes de fréquence divisées (B1 à B10) et auxquelles ledit signal d'entrée est appliqué, ledit dispositif de détection comprend des détecteurs de niveau (3A à 3J) reliés respectivement aux signaux de sortie desdits filtres passe-bande (2A à 2J) pour fournir les signaux de sortie détectés correspondant, des convertisseurs analogiques-numériques (4A à 4J) pour convertir lesdits signaux de sortie détectés correspondant aux signaux numériques, et des décodeurs (5A à 5J) recevant un desdits signaux numériques respectifs et fournissant des valeurs indicatrices des niveaux correspondants, et dans lesquels lesdits dispositifs d'opérations arithmétiques (10A à 10I) sont fonctionnels pour calculer lesdits niveaux des signaux des bandes de fréquence situées entre lesdites bandes de fréquence divisées (B1 à B10) voisines de celles-ci à partir desdites valeurs indicatrices des niveaux correspondants auxdites bandes de fréquence divisées voisines.

6. Analyseur de spectre selon la revendication 5, dans lequel lesdits dispositifs d'opérations arithmétiques (10A à 10I) sont fonctionnels pour calculer ledit niveau du signal de chacune desdites bandes de fréquence situées entre lesdites bandes de fréquence divisées (B1 à B10) comme la valeur moyenne desdites valeurs indicatrices des niveaux correspondant aux bandes de fréquence divisées voisines de celles-ci.
